# EUROPEAN PATENT SPECIFICATION

(11) **EP 3 709 034 B1**
(45) Date of publication and mention of the grant of the patent: **07.05.2025**
(21) Application number: 19162976.5
(22) Date of filing: 14.03.2019
(51) Int. Cl.: G01R 29/08

(54) **MEASUREMENT SYSTEM, MEASUREMENT SETUP AS WELL AS METHOD FOR TESTING A SYSTEM UNDER TEST**
MESSSYSTEM, MESSAUFBAU SOWIE VERFAHREN ZUR PRÜFUNG EINES ZU PRÜFENDEN SYSTEMS
SYSTÈME DE MESURE, CONFIGURATION DE MESURE, AINSI QUE PROCÉDÉ PERMETTANT DE TESTER UN SYSTÈME EN COURS DE TEST

(43) Date of publication of application: 16.09.2020
(73) Proprietor: Rohde & Schwarz GmbH & Co. KG, 81671 München (DE)
(72) Inventor: NASEEF, Mahmud, 81671 München (DE); REIMER, Christian, 81671 München (DE)
(74) Representative: Novagraaf Group

(56) References cited:
- EP-A1- 3 273 257
- WO-A2-2018/128950
- US-A1- 2010 233 969
- US-A1- 2010 285 753
- US-A1- 2011 237 246
- US-A1- 2017 294 973
- US-A1- 2019 028 216
- US-B1- 9 991 592

## Description

The invention concerns a measurement setup as well as a method for testing a system under test, in particular for over the air proximity tests.

With the rise of the Internet of Things, evermore systems are provided with wireless connectivity for communication with other systems. For this purpose, the systems are provided with radio devices, sometimes more than one radio device. The radio devices have to be robust against interference, especially from interference of signals dedicated for the other radio device of the system.

US 2011/0237246 A1 discloses a mobile device with multiple communication modules and a software-based method for mitigating interference between the communication modules.

EP 3 273 257 A1 shows a system for OTA tests of a device under test having a communication antenna and an interference antenna, each being mounted on a separate positioner.

US 2010/0233969 A1 discloses a test chamber for testing devices having an interference source coupled to the chamber by an interference antenna.

US 9 991 592 B1 shows a test system for OTA tests of a device under test having a plurality of antennas, all of which being controlled by a single communication controller.

An example of such a system may be a vehicle with an entertainment system having a cellular radio device and a Wi-Fi radio device.

The radio devices have to be thoroughly tested, for example by over the air proximity tests to reproduce real world scenarios. Proximity tests are sometimes also called proximity coexistence tests.

However, as the dimensions of these systems are very large, such tests are difficult to carry out.

Thus, it is the object of the invention to provide a measurement setup as well as a method for performing over the air proximity tests in a simple and cost-efficient manner.

For this purpose, a measurement setup according to claim 1 is provided.

By providing a communication tester for a communication link and an interference antenna emitting an interference signal, the robustness of the radio device of the device under test may easily be tested under real world conditions. Further, antenna characteristics may be eliminated from the measurement.

The interference signal generator may be a vector signal generator.

For example, the quality of the communication link comprises information about the throughput, the block error rate (BLER), the bit error rate (BER) and/or the packet error rate (PER) of the communication link. Thus, easily accessible measures for the quality may be used.

In an aspect, the at least one interference signal and the communication link are statistically independent, are uncorrelated, use different channels and/or are of a different communication standard, allowing a clear distinction between the communication link and interference.

Use of a standard implies the use of the protocol specified in the respective standard. The communication link and/or the interference signal may be a signal according to the Bluetooth, LTE, 5G or Wifi standard.

In an embodiment of the invention, the measurement system comprises at least one first interference antenna and at least one second interference antenna, wherein the at least one first interference antenna is located at a first interference position with respect to the system under test and the at least one second interference antenna is positioned at a second interference position with respect to the system under test, particularly wherein the first interference position and/or the second interference position is in a range of up to 10 m, in particular up to 25 m away from the system under test. Hence, complex scenarios may be tested.

For reducing equipment costs, the first interference antenna and the second interference antenna may be selectively connected to the interference signal generator via an antenna switch unit of the measurement system.

The measurement system may comprises two interference signal generators connected to the first interference antenna and the second interference antenna, respectively, in order to model a real world scenario precisely.

In an embodiment, the system under test comprises a second radio device supporting a second communication standard, particularly wherein the interference signal is a signal according to the second communication standard, allowing very realistic testing.

The communication link may be cellular, i.e. using the LTE or 5G standard, and the interference signal may be a WIFI signal. For example, the second radio device is a WIFI Access point.

In order to reduce manufacturing costs, the first radio device and the second radio device are integrated on the same chip of the system under test.

In an embodiment of the invention, the system under test comprises a vehicle, particularly wherein the at least one first interference antenna, the at least one second interference antenna and/or the communication antenna are located inside the vehicle. This way, communication robustness of vehicle systems may be assessed.

In order to create a test environment resembling a situation in traffic, the first interference antenna and/or the second interference antenna is positioned in a range of about one or several lane width and/or of about one or several vehicle dimensions away from the system under test.

The lane width may be the lane width of a highway, e.g. between 3 and 4 meters.

Further, for above purpose a method according to claim 10 is provided.

The features and advantages discussed in the context of the measurement system and the measurement setup also apply to the method and vice versa.

For a very precise assessment of the blocking level, the method may have the following steps:
a) adjusting the relative position and/or alignment of the system under test and the communication antenna until the maximum coupling between the communication antenna and the first radio device is achieved,
b) reducing the power of the of the communication signal to a reduced power until a predefined deterioration of the quality of the communication link is obtained,
c) recording the value of the reduced power,
d) increasing the power of the communication signal to a testing power, in particular to full power,
e) increasing the power of the at least one interference signal to an interference power until the quality of the communication link has deteriorated to the predefined deterioration, and
f) determining a blocking level based on the value of the reduced power and the value of the interference power, particularly wherein the interference position, the alignment of the at least one interference antenna and/or the position and/or alignment of the communication antenna relative to the system under test are used to determine the blocking level.

The interference power is, for example, the total power of the interference signals.

In a variant, the interference antenna is located at a first interference position for a first phase of the method and the interference antenna is located at a second interference position for a second phase of the method. This way, the hardware costs are reduced.

In order to allow a quick and reliable measurement, the system under test, in particular the vehicle, is rotated relative to the communication antenna using a rotation mechanism, in particular a turntable.

Further features and advantages will be apparent from the following description as well as the accompanying drawings, to which reference is made. In the drawings:
- Figure 1 shows schematically a measurement setup according to the invention having a measurement system according to the invention,
- Figures 2a and 2b show a schematic top view of the system according to Figure 1 at two different steps while carrying out a method according to the invention,
- Figure 3 shows a flow-chart of a method according to the invention,
- Figures 4a and 4b show a second embodiment of the measurement setup according to the invention at two different phases of a second embodiment of a method according to the invention,
- Figure 5 shows a flow-chart of a second embodiment of a method according to the invention, and
- Figure 6 shows a third embodiment of the measurement setup according to the invention.

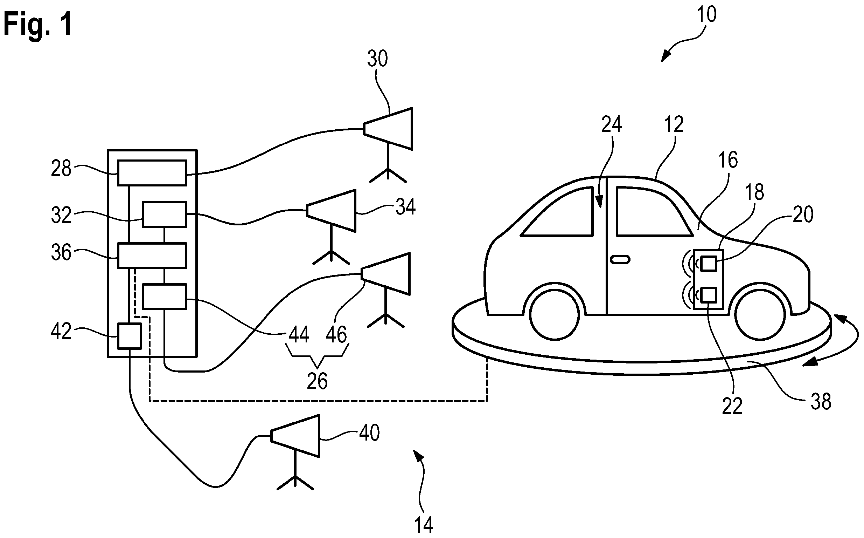

Figure 1 shows very schematically a measurement setup 10 comprising a system under test 12 (SUT) and a measurement system 14.

In the shown embodiment, the system under test 12 is a vehicle 16, for example a passenger car. Of course, the system under test 12 may also be any other system like a refrigerator, a wagon of a train, or the like.

The system under test 12, e.g. the vehicle 16 comprises a communication and entertainment system 18 having a first radio device 20 and a second radio device 22, as well as a passenger cabin 24.

The first radio device 20 is configured to communicate using a first communication standard, and the second radio device 22 is configured to communicate using a second communication standard.

The first communication standard and the second communication standard may be the same standard or different standards. The first communication standard and the second communication standard may be chosen from a Bluetooth, LTE, 5G and Wi-Fi standard.

The first radio device 20 and the second radio device 22 may be integrated on the same chip of the entertainment system 18 of the vehicle 16.

For example, the first radio device 20 is a cellular user equipment, e.g. supporting the LTE and/or 5G communication standard, and the second radio device 22 is a Wi-Fi access point supporting the Wi-Fi standard.

The measurement system 14 comprises a communication tester 26, a first interference signal generator 28 with an associated first interference antenna 30, a second interference signal generator 32 and an associated second interference antenna 34, a control unit 36 and a rotation mechanism 38, for example a turntable.

Optionally, the measurement system 14 may comprise a receive antenna 40 connected to a signal analyzer 42.

The communication tester 26 comprises a signal generator 44 and a communication antenna 46. The communication signal generator 44 may be a vector signal generator.

The control unit 36 controls and is connected to - especially via a cable-bound connection - the first interference signal generator 28, the second interference signal generator 32 and the communication signal generator 44. Further, the control unit 36 may be connected to the signal analyzer 42.

Of course, the control unit 36 is also connected to the rotation mechanism 38 to control the movement of the rotation mechanism 38.

For measuring the system under test 12, the system under test 12 is placed on the rotation mechanism 38 and the first interference antenna 30, the second interference antenna 34, the communication antenna 46 and the optional receive antenna 40 are located outside and/or inside (of the system under test 12), e.g. inside the passenger cabin 24 of the vehicle 16.

The communication antenna 46 is placed at a communication position P_{C} and directed towards the system under test 12, the first interference antenna 30 is placed at a first interference location P_{I1}, the second interference antenna 34 is located at a second interference position P_{I2} and the optional receive antenna 40 is placed at a received position P_{R}.

All of the antennas 30, 34, 46, 40 are directed towards the system under test 12.

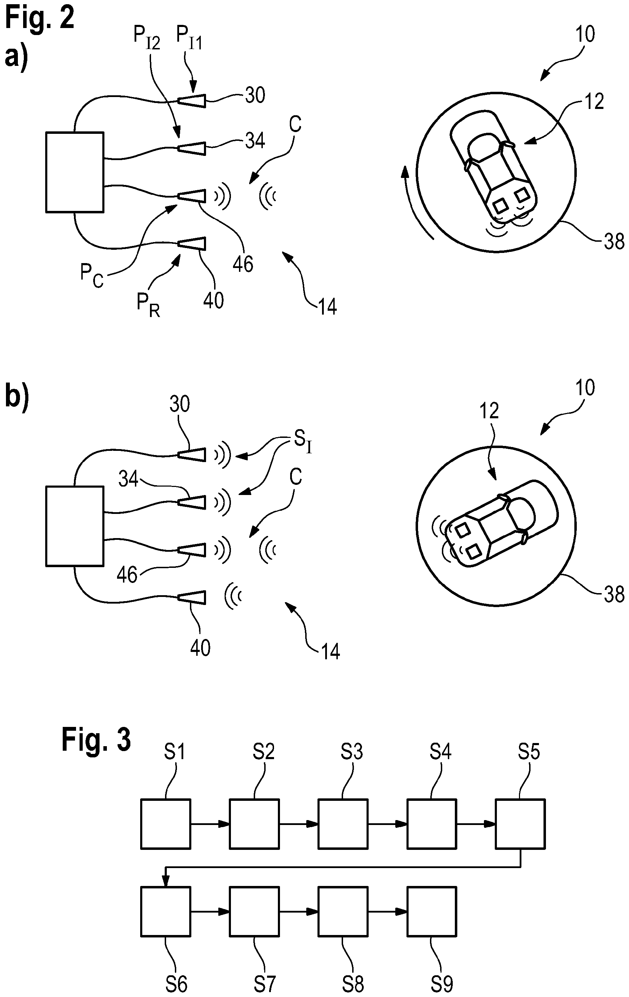

The resulting situation can be seen in Figure 2a schematically.

In the shown first embodiment, all of the antenna positions P_{C}, P_{I1}, P_{I2}, P_{R} are located outside the system under test 12. For example, the first and the second interference position P_{I1}, P_{I2} are positioned in a range of up to 10 m, in particular up to 25 m away from the rotation mechanism 38 and thus the system under test 12.

Alternatively, the first and the second interference positions P_{I1}, P_{I2} may be located at a distance away from the rotation mechanism 38 and the system under test 12 corresponding to about one or more widths of a lane of a highway and/or one or more dimensions of a vehicle.

For example, a lane width of a highway is between about 3 m and 4 m.

Measurement setups in which the distance between the interference positions P_{I1}, P_{I2} is in a range of a lane width and/or a vehicle dimension, represent situations, in which the vehicle 16 drives on a highway with other cars surrounding the vehicle 16.

For performing an over the air proximity test of the system under test 12, the method shown in Figure 3 is carried out.

In a first step S1, a communication link c is established over the air between the communication tester 26 and the first radio device 20 over the air.

The communication link c is continuous and held stable by the communication tester 26.

For this purpose, the communication signal generator 44 generates a communication signal with a predefined signal power and the communication signal is emitted using the communication antenna 46.

In step S2, the relative position of the system under test 12, more precisely the position of the first radio device 20 and the communication antenna 46 is adjusted to receive the optimum coupling. This is done by rotating the system under test 12 on the rotating mechanism 38 and evaluating the quality of the communication link, for example by measuring the throughput, the block error rate (BLER), the bit error rate (BER) and/or the packet error rate (PER) of the communication link. The communication tester 26 and/or the control unit 36 are configured to evaluate the quality of the communication link c.

The optimization is done by rotating the system under test 12 until a maximum of the quality of the communication link c is obtained. This situation can be, for example, seen in Figure 2b, where the system under test 12, i.e. the vehicle 16, has been rotated with respect to the measurement system 14.

The adjustment of the relative position may also be performed with a test signal before the communication link has been established in step S1.

In the next step S3, the power of the communication signal is reduced until a predefined deterioration, for example 10 % loss of throughput, is achieved.

The value of the power of the communication signal leading to the predefined deterioration is recorded as the value of the reduced power by the control unit 36 or the radio communication tester 26 (step S4).

In the next step, the power of the communication signal is then increased to a testing power, in particular to the full power that may also be the same power that has been used during the adjustment of the relative position (step S5).

Subsequently in step S6, interference signals S_{I} are generated by the interference signal generators 28, 32 and emitted by the respective interference antennas 30, 34.

The interference signals S_{I} are for example signals of the second communication standard used by the second radio device 22. It is also possible, that the interference signals S_{I} simulate or establish a communication link with the second radio device 22.

The signal power of the interference signals S_{I} depends upon the position, namely the incident angle, of the beam of the interference antenna 30, 34, also called interference antenna beam of the interference antenna 30, 34, to the system under test 12.

The interference signals S_{I} and the communication link C are uncorrelated and statistically independent. If the interference signals S_{I} and the communication link make use of the same communication standard, i.e. the same communication protocol, different channels may be used. It is also possible, that the communication link C and the interference signal S_{I} are of different communication standards.

The control unit 36 and/or the radio communication tester 26 evaluate the quality of the communication link C, in particular continuously (step S7).

In step S8, the power of the interference signal S_{I}, for example the total power of all of the interference signals emitted by the interference antennas 30, 34, is increased until the quality of the communication link C has deteriorated to the predefined deterioration. The predefined deterioration is the same predefined deterioration that has been used to determine the reduced power in steps S3, S4. The value of the power of the interference signals S_{I} at the occurrence of the predefined deterioration is recorded.

In the next step S9, the control unit 36 and/or the radio communication tester 26 determine a blocking level, i.e. a measure for the interference caused by the interference signals S_{I}, based on the value of the reduced power recorded in step S4 and the value of the interference power recorded at step S8. The blocking level may be, in a simple case, the difference between the value of the reduced power and the value of the interference power.

In order to determine more complex blocking levels, also the position and alignment of the communication antenna 46 and/or the position and alignment of the interference antennas 30, 34 may be used to determine the blocking level.

During the test, the receive antenna 40 may receive spurious emissions from the system under test 12 that may be analyzed using the signal analyzer 42.

In this way, a quick and reliable way of determining the robustness of the first radio device 20 against interference, especially interference of signals for the second radio device 22, can be effectively determined.

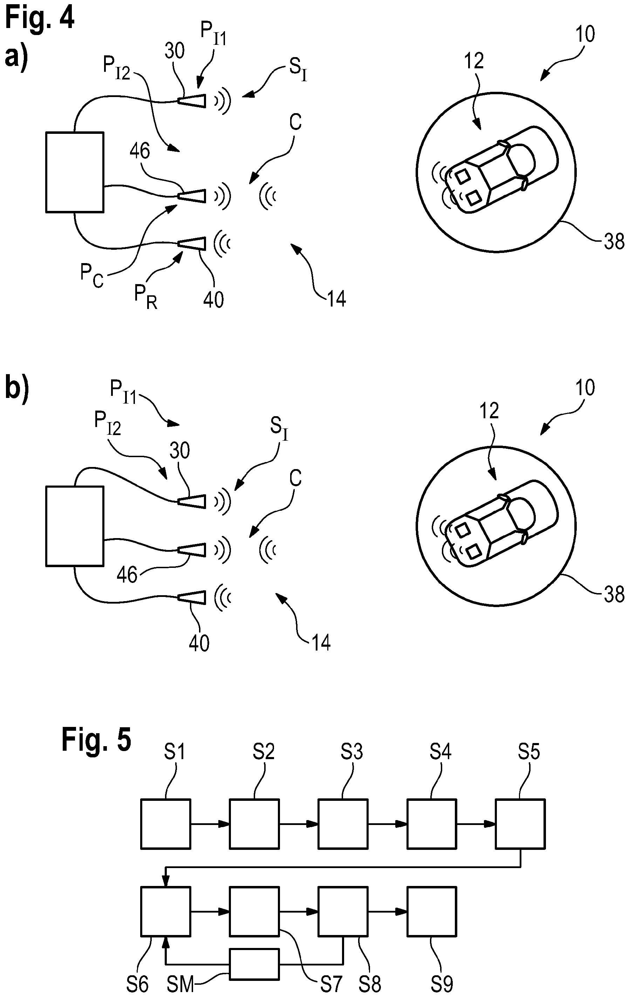

A second embodiment of the measurement setup 10 and the method are shown in Figures 4 and 5. The second embodiment corresponds essentially to the first embodiment so that only the differences are explained in the following. Same and functionally the same components and steps are referred to with the same reference numbers.

Figures 4a and 4b show the measurement setup 10 during two different phases of the test of the system under test 12.

In the second embodiment, the measurement system 14 comprises only the first interference signal generator 28 and the first interference antenna 30.

In the second embodiment of the method, steps S1 to S5 are carried out as explained for the first embodiment.

However, the steps S6, S7 and S8 are carried out repeatedly, wherein each iteration of the set of steps S6, S7 and S8 is called a phase in the following.

A flow-chart of a method of the second embodiment is shown in Figure 5.

In the first phase, i.e. the first iteration of steps S6, S7 and S8, the first interference antenna 30 is located at the first interference position P_{I1} (Fig. 4a). With this arrangement, the first phase, i.e. the steps S6, S7, S8 are carried out as described for the first embodiment.

After step S8 has been completed, i.e. after the first phase, the first interference antenna 30 is moved to the second interference position P_{I2} (step SM).

With the first interference antenna 30 at the second interference position P_{I2}, the second phase is carried out, i.e. steps S6 to S8 are performed again (Fig. 4b).

After the second phase, i.e. the second iteration of step S8, the blocking level is determined using all of the recorded values of the interference powers during the phases (step S9).

It is of course possible that more than two phases are carried out so that more than two interference positions may be used.

In the second embodiment, the quantity of equipment needed can be reduced compared to the first embodiment.

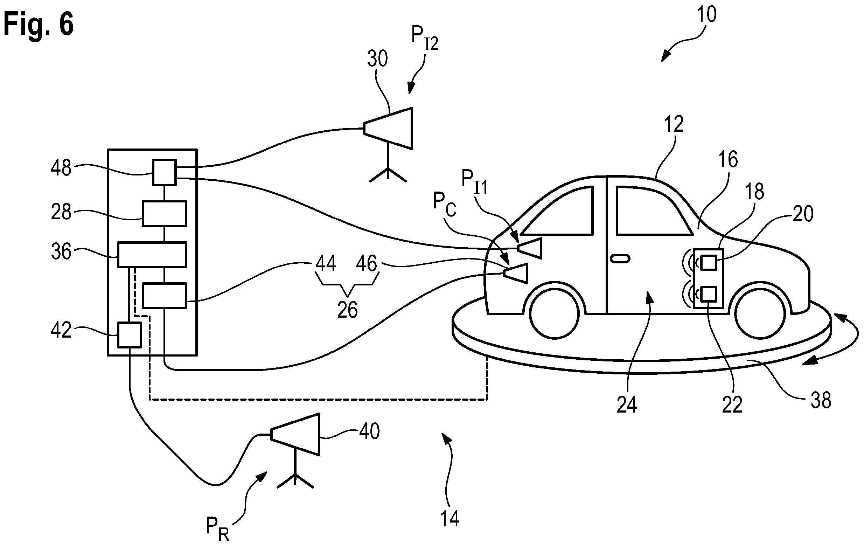

Figure 6 shows a third embodiment of the measurement setup 10 being essentially the same as the measurement setup 10 of the first embodiment so that only the differences are explained in the following. Same and functionally the same parts or steps are referred to with the same reference numerals.

In the third embodiment, the first interference antenna 30 and the communication antenna 46 are located inside the system under test 12. In the shown embodiment, the first interference antenna 30 and the communication antenna 46 are located inside the vehicle 16, for example inside the passenger cabin 24.

Another difference to the first embodiment lies in the fact that only the first interference signal generator 28 is provided. The first interference antenna 30 and the second interference antenna 34 are connected to the first interference signal generator 32 via an antenna switch unit 48 of the measurement system 14.

The antenna switch unit 48 and the first interference signal generator 28 may be controlled in a way that the first interference antenna 30 and the second interference antenna 34 are fed in very short intervals so that both antennas 30 and 34 emit interference signals S_{I} virtually simultaneously.

In this case, the method according to the first embodiment (Fig. 3) may be carried out.

It is however possible, that the antenna control unit 36 and the first interference signal generator 28 are controlled so that either the first interference antenna 30 or the second interference antenna 34 emits an interference signal S_{I}.

In this case, the method according to the second embodiment (Fig. 5) may be carried out, wherein one of the interference antennas 30, 34 is fed with the signal during the first phase and the other is fed with the interference signal during the second phase. The step SM of moving the antenna 30 is then replaced by switching of the antenna switch unit 48.

With any of the measurement setups 10 of the three embodiments, various real world scenarios may be tested.

For example, with a measurement setup 10 according to the first embodiment, a situation of a vehicle 16 driving on a highway with various other vehicles surrounding may be simulated. In this case, the communication link C may be a cellular communication link using the LTE or 5G standard and the interference antennas 30, 34 are placed at a distance to the vehicle simulating a traffic situation. For example, the interference antennas 30, 34 are within a range of the width of one or two highway lanes or within one of several vehicle dimensions. The interference signals S_{I} may be of the Wi-Fi or Bluetooth standard simulating hotspots of other vehicles.

In a different scenario, that may be simulated with the measurement setup 10 according to the second embodiment, the interference of a Wi-Fi hotspot provided by the entertainment system 18 of the vehicle 16 is tested. In this case, the communication link C may be of the Wi-Fi standard and also the interference signal S_{I} of the first interference antenna 30 within the vehicle 16 may also be of the Wi-Fi standard simulating a second device within the vehicle 16.

Of course, the interference signal S_{I} of the first interference antenna 30 may be of a cellular standard, like LTE or 5G, simulating a mobile device within the vehicle 16.

The interference signal S_{I} emitted by the second interference antenna 34 outside of the vehicle 16 may be a cellular signal, i.e. LTE or 5G, simulating a cellular base station.

Of course, the shown embodiments are not limited to the number of interference antennas or interference signal generators present in the shown examples. Of course, more interference antennas and more signal generators may be used. Likewise, the antennas 30, 34, 46 may be placed inside or outside the system under test 12 depending on the scenario to be tested.

Further, a combination of the different features of the embodiments is also possible. For example, the interference antennas of the third embodiment may each have the dedicated interference signal generator. Likewise, a single interference antenna may be used subsequently outside and inside the vehicle to achieve the scenario of the third embodiment.

## Claims

1. Measurement setup for testing a system under test (12), in particular for over the air proximity tests, having a system under test (12) and a measurement system (14) for testing the system under test (12), in particular for over the air proximity tests,
wherein the system under test (12) comprises at least one first radio device (20) supporting a first communication standard,
the measurement system (14) comprising:
a communication tester (26) with a communication antenna (46) for establishing a communication link (C) over the air with the first radio device (20) of the system under test (12), wherein the communication tester (26) and the first radio device (20) are connected over the air using a communication link (C) of the first communication standard
at least one interference signal generator (28, 32) configured to generate at least one interference signal (S_{I}) interfering with the communication link (C) established by the communication tester (26), wherein the at least one interference signal (S_{I}) and the communication link (C) are independent from one another, and
at least one interference antenna (30, 34) connected to the interference signal generator (28) for emitting the interference signal (S_{I}), wherein the at least one interference antenna (30, 34) is located at at least one interference position (P_{I1}, P_{I2}) with respect to the system under test (12),
wherein the communication tester (26) is configured to evaluate the quality of the communication link (C),
**characterized in that** at least one interference signal generator (28, 32) is configured for controlling the interference signal power emitted from the at least one interference antenna (30, 34) depending on an incident angle of an interference antenna beam of the interference antenna (30, 34) with respect to the system under test (12).

2. Measurement setup according to claim 1, **characterized in that** the quality of the communication link (C) comprises information about the throughput, the block error rate, the bit error rate and/or the packet error rate of the communication link.

3. Measurement setup according to claim 1 or 2, **characterized in that** the at least one interference signal (S_{I}) and the communication link (C) are statistically independent, are uncorrelated, use different channels and/or are of a different communication standard.

4. Measurement setup according to any one of the preceding claims, **characterized in that** the measurement system (14) comprises at least one first interference antenna (30) and at least one second interference antenna (34), wherein the at least one first interference antenna (30, 34) is located at a first interference position (P_{I1}) with respect to the system under test (12) and the at least one second interference antenna (34) is positioned at a second interference position (P_{I2}) with respect to the system under test (12), particularly wherein the first interference position (P_{I1}) and/or the second interference position (P_{I2}) is in a range of up to 10 m, in particular up to 25 m away from the system under test (12).

5. Measurement setup according to claim 4, **characterized in that** the first interference antenna (30) and the second interference antenna (34) are selectively connected to the at least one interference signal generator (28, 32) via an antenna switch unit (48) of the measurement system (14) or **in that** the measurement system (14) comprises two interference signal generators (28, 32) connected to the first interference antenna (30) and the second interference antenna (34), respectively.

6. Measurement setup according to any one of the preceding claims, **characterized in that** the system under test (12) comprises a second radio device (22) supporting a second communication standard, particularly wherein the interference signal (S_{I}) is a signal according to the second communication standard.

7. Measurement setup according to claim 6, **characterized in that** the first radio device (20) and the second radio device (22) are integrated on the same chip of the system under test (12).

8. Measurement setup according to any one of the preceding claims, **characterized in that** the system under test (12) comprises a vehicle (16), particularly wherein the at least one first interference antenna (30), the at least one second interference antenna (34) and/or the communication antenna (46) are located inside the vehicle (16).

9. Measurement setup according to claim 8, **characterized in that** the first interference antenna (30) and/or the second interference antenna (34) is positioned in a range of about one or several a lane width and/or of about one or several vehicle dimensions away from the system under test (12).

10. Method for testing a system under test (12) with at least a first radio device (20), in particular for over the air proximity tests, using a measurement setup (10) according to any one of the preceding claims, the method comprising the following steps:
a) establishing a communication link (C) over the air between the communication tester (26) and the at least one first radio device (20) via the communication tester (26) emitting a communication signal (C),
b) emitting at least one interference signal (S_{I}) directed to the system under test (12), and
c) evaluating the quality of the communication link (C), in particular by the communication tester (26)
**characterized in that** the interference signal power emitted from the at least one interference antenna (30, 34) depends on an interference antenna beam of the interference antenna (30, 34) with respect to the system under test (12).

11. Method according to claim 10, **characterized by** the following steps:
a) adjusting the relative position and/or alignment of the system under test (12) and the communication antenna (46) until the maximum coupling between the communication antenna (46) and the first radio device (20) is achieved,
b) reducing the power of the of the communication signal to a reduced power until a predefined deterioration of the quality of the communication link (C) is obtained,
c) recording the value of the reduced power,
d) increasing the power of the communication signal to a testing power, in particular to full power,
e) increasing the power of the at least one interference signal (S_{I}) to an interference power until the quality of the communication link (C) has deteriorated to the predefined deterioration, and
f) determining a blocking level based on the value of the reduced power and the value of the interference power, particularly wherein the interference position (P_{I1}, P_{I2}), the alignment of the at least one interference antenna (30, 34) and/or the position and/or alignment of the communication antenna (46) relative to the system under test (12) are used to determine the blocking level.

12. Method according to claim 10 or 11, **characterized in that** the at least one interference antenna (30, 34) is located at a first interference position (P_{I1}) for a first phase of the method and the at least one interference antenna (30, 34) is located at a second interference position (P_{I2}) for a second phase of the method.

13. Method according to any one of the claims 10 to 12, **characterized in that** the system under test (12), in particular the vehicle (16), is rotated relative to the communication antenna (46) using a rotation mechanism (38), in particular a turntable.

## Patentansprüche

1. Messaufbau zum Testen eines zu testenden Systems (12), insbesondere für terrestrische Näherungstests, der ein zu testenden System (12) und ein Messsystem (14) zum Testen des zu testenden Systems (12), insbesondere für terrestrische Näherungstests, aufweist,
wobei das zu testende System (12) mindestens eine erste Funkvorrichtung (20), die einen ersten Kommunikationsstandard unterstützt, umfasst,
das Messsystem (14) umfassend:
eine Kommunikationstesteinrichtung (26) mit einer Kommunikationsantenne (46) zum Herstellen einer terrestrischen Kommunikationsverbindung (C) mit der ersten Funkvorrichtung (20) des zu testenden Systems (12), wobei die Kommunikationstesteinrichtung (26) und die erste Funkvorrichtung (20) unter Verwendung einer Kommunikationsverbindung (C) des ersten Kommunikationsstandards terrestrisch aneinander angeschlossen sind, mindestens einen Störsignalgenerator (28, 32), der konfiguriert ist, um mindestens ein Störsignal (S_{I}) zu generieren, das die Kommunikationsverbindung (C), die durch die Kommunikationstesteinrichtung (26) hergestellt wird, stört, wobei das mindestens eine Störsignal (S_{I}) und die Kommunikationsverbindung (C) voneinander unabhängig sind, und mindestens eine Störantenne (30, 34), die an den Störsignalgenerator (28) angeschlossen ist, zum Aussenden des Störsignals (S_{I}), wobei sich die mindestens eine Störantenne (30, 34) an mindestens einer Störposition (P_{I1}, P_{I2}) in Bezug auf das zu testende System (12) befindet,
wobei die Kommunikationstesteinrichtung (26) konfiguriert ist, um die Qualität der Kommunikationsverbindung (C) zu bewerten,
**dadurch gekennzeichnet, dass** mindestens ein Störsignalgenerator (28, 32) zum Steuern der Störsignalleistung, die von der mindestens einen Störantenne (30, 34) ausgesendet wird, abhängig von einem Einfallswinkel eines Störantennenstrahls der Störantenne (30, 34) in Bezug auf das zu testende System (12) konfiguriert ist.

2. Messaufbau nach Anspruch 1, **dadurch gekennzeichnet, dass** die Qualität der Kommunikationsverbindung (C) Informationen über den Durchsatz, die Blockfehlerrate, die Bitfehlerrate und/oder die Paketfehlerrate der Kommunikationsverbindung umfasst.

3. Messaufbau nach Anspruch 1 oder 2, **dadurch gekennzeichnet, dass** das mindestens eine Störsignal (S_{I}) und die Kommunikationsverbindung (C) statistisch unabhängig sind, unkorreliert sind, unterschiedliche Kanäle verwenden und/oder einem unterschiedlichen Kommunikationsstandard entsprechen.

4. Messaufbau nach einem der vorstehenden Ansprüche,
**dadurch gekennzeichnet, dass** das Messsystem (14) mindestens eine erste Störantenne (30) und mindestens eine zweite Störantenne (34) umfasst, wobei sich die mindestens eine erste Störantenne (30, 34) an einer ersten Störposition (P_{I1}) in Bezug auf das zu testende System (12) befindet und die mindestens eine zweite Störantenne (34) an einer zweiten Störposition (P_{I2}) in Bezug auf das zu testende System (12) positioniert ist, wobei insbesondere die erste Störposition (P_{I1}) und/oder die zweite Störposition (P_{I2}) in einer Reichweite von bis zu 10 m, insbesondere bis zu 25 m von dem zu testenden System (12) entfernt liegt.

5. Messaufbau nach Anspruch 4, **dadurch gekennzeichnet, dass** die erste Störantenne (30) und die zweite Störantenne (34) über eine Antennenschalteinheit (48) des Messsystems (14) an den mindestens einen Störsignalgenerator (28, 32) selektiv angeschlossen sind oder **dass** das Messsystem (14) zwei Störsignalgeneratoren (28, 32) umfasst, die an die erste Störantenne (30) beziehungsweise die zweite Störantenne (34) angeschlossen sind.

6. Messaufbau nach einem der vorstehenden Ansprüche,
**dadurch gekennzeichnet, dass** das zu testende System (12) eine zweite Funkvorrichtung (22), die einen zweiten Kommunikationsstandard unterstützt, umfasst, wobei insbesondere das Störsignal (S_{I}) ein Signal gemäß dem zweiten Kommunikationsstandard ist.

7. Messaufbau nach Anspruch 6, **dadurch gekennzeichnet, dass** die erste Funkvorrichtung (20) und die zweite Funkvorrichtung (22) auf demselben Chip des zu testenden Systems (12) integriert sind.

8. Messaufbau nach einem der vorstehenden Ansprüche,
**dadurch gekennzeichnet, dass** das zu testende System (12) ein Fahrzeug (16) umfasst, wobei sich insbesondere die mindestens eine erste Störantenne (30), die mindestens eine zweite Störantenne (34) und/oder die Kommunikationsantenne (46) innerhalb des Fahrzeugs (16) befinden.

9. Messaufbau nach Anspruch 8, **dadurch gekennzeichnet, dass** die erste Störantenne (30) und/oder die zweite Störantenne (34) in einer Reichweite von etwa einer oder mehreren Fahrspurbreiten und/oder von etwa einer oder mehreren Fahrzeugabmessungen von dem zu testenden System (12) entfernt positioniert ist.

10. Verfahren zum Testen eines zu testenden Systems (12) mit mindestens einer ersten Funkvorrichtung (20), insbesondere für terrestrische Näherungstests, unter Verwendung eines Messaufbaus (10) nach einem der vorstehenden Ansprüche, das Verfahren umfassend die folgenden Schritte:
a) Herstellen einer terrestrischen Kommunikationsverbindung (C) zwischen der Kommunikationstesteinrichtung (26) und der mindestens einen ersten Funkvorrichtung (20) über das Aussenden eines Kommunikationssignals (C) durch die Kommunikationstesteinrichtung (26),
b) Aussenden mindestens eines Störsignals (S_{I}), das auf das zu testende System (12) gerichtet ist, und
c) Bewerten der Qualität der Kommunikationsverbindung (C), insbesondere durch die Kommunikationstesteinrichtung (26)
**dadurch gekennzeichnet, dass** die Störsignalleistung, die von der mindestens einen Störantenne (30, 34) ausgesendet wird, von einem Störantennenstrahl der Störantenne (30, 34) in Bezug auf das zu testende System (12) abhängt.

11. Verfahren nach Anspruch 10, **gekennzeichnet durch** die folgenden Schritte:
a) Einstellen der relativen Position und/oder Ausrichtung des zu testenden Systems (12) und der Kommunikationsantenne (46), bis die maximale Kopplung zwischen der Kommunikationsantenne (46) und der ersten Funkvorrichtung (20) erreicht ist,
b) Reduzieren der Leistung des Kommunikationssignals auf eine reduzierte Leistung, bis eine vordefinierte Verschlechterung der Qualität der Kommunikationsverbindung (C) erhalten wird,
c) Aufzeichnen des Werts der reduzierten Leistung,
d) Erhöhen der Leistung des Kommunikationssignals auf eine Testleistung, insbesondere auf eine volle Leistung,
e) Erhöhen der Leistung des mindestens einen Störsignals (S_{I}) auf eine Störleistung, bis sich die Qualität der Kommunikationsverbindung (C) auf die vordefinierte Verschlechterung verschlechtert hat, und
f) Bestimmen eines Sperrpegels basierend auf dem Wert der reduzierten Leistung und dem Wert der Störleistung, wobei insbesondere die Störposition (P_{I1}, P_{I2}), die Ausrichtung der mindestens einen Störantenne (30, 34) und/oder die Position und/oder Ausrichtung der Kommunikationsantenne (46) relativ zu dem zu testenden System (12) verwendet werden, um den Sperrpegel zu bestimmen.

12. Verfahren nach Anspruch 10 oder 11, **dadurch gekennzeichnet, dass** sich die mindestens eine Störantenne (30, 34) an einer ersten Störposition (P_{I1}) für eine erste Phase des Verfahrens befindet und sich die mindestens eine Störantenne (30, 34) an einer zweiten Störposition (P_{I2}) für eine zweite Phase des Verfahrens befindet.

13. Verfahren nach einem der Ansprüche 10 bis 12,
**dadurch gekennzeichnet, dass** das zu testende System (12), insbesondere das Fahrzeug (16), unter Verwendung eines Rotationsmechanismus (38), insbesondere einer Drehscheibe, relativ zu der Kommunikationsantenne (46) rotiert wird.

## Revendications

1. Configuration de mesure permettant de tester un système sous test (12), en particulier pour des tests de proximité par voie aérienne, ayant un système sous test (12) et un système de mesure (14) permettant de tester le système sous test (12), en particulier pour des tests de proximité par voie aérienne,
dans laquelle le système sous test (12) comprend au moins un premier dispositif radio (20) supportant une première norme de communication,
le système de mesure (14) comprenant :
un testeur de communication (26) avec une antenne de communication (46) permettant d'établir une liaison de communication (C) par voie aérienne avec le premier dispositif radio (20) du système sous test (12), le testeur de communication (26) et le premier dispositif radio (20) étant connectés par voie aérienne à l'aide d'une liaison de communication (C) de la première norme de communication
au moins un générateur de signal d'interférence (28, 32) configuré pour générer au moins un signal d'interférence (S_{I}) interférant avec la liaison de communication (C) établie par le testeur de communication (26), l'au moins un signal d'interférence (S_{I}) et la liaison de communication (C) étant indépendants l'un de l'autre, et
au moins une antenne d'interférence (30, 34) connectée au générateur de signal d'interférence (28) pour émettre le signal d'interférence (S_{I}), l'au moins une antenne d'interférence (30, 34) étant placée au niveau d'au moins une position d'interférence (P_{I1}, P_{I2}) par rapport au système sous test (12),
dans laquelle le testeur de communication (26) est configuré pour évaluer la qualité de la liaison de communication (C),
**caractérisée en ce qu'**au moins un générateur de signal d'interférence (28, 32) est configuré pour commander la puissance de signal d'interférence émise de l'au moins une antenne d'interférence (30, 34) en fonction d'un angle incident d'un faisceau d'antenne d'interférence de l'antenne d'interférence (30, 34) par rapport au système sous test (12).

2. Configuration de mesure selon la revendication 1, **caractérisée en ce que** la qualité de la liaison de communication (C) comprend des informations sur le débit, le taux d'erreur de bloc, le taux d'erreur de bit et/ou le taux d'erreur de paquet de la liaison de communication.

3. Configuration de mesure selon la revendication 1 ou 2,
**caractérisée en ce que** l'au moins un signal d'interférence (S_{I}) et la liaison de communication (C) sont statistiquement indépendants, ne sont pas corrélés, utilisent des canaux différents et/ou sont d'une norme de communication différente.

4. Configuration de mesure selon l'une quelconque des revendications précédentes, **caractérisée en ce que** le système de mesure (14) comprend au moins une première antenne d'interférence (30) et au moins une seconde antenne d'interférence (34), dans laquelle l'au moins une première antenne d'interférence (30, 34) est située au niveau d'une première position d'interférence (P_{I1}) par rapport au système sous test (12) et l'au moins une seconde antenne d'interférence (34) est positionnée au niveau d'une seconde position d'interférence (P_{I2}) par rapport au système sous test (12), en particulier dans laquelle la première position d'interférence (P_{I1}) et/ou la seconde position d'interférence (P_{I2}) est dans une plage allant jusqu'à 10 m, en particulier jusqu'à 25 m à distance du système sous test (12).

5. Configuration de mesure selon la revendication 4, **caractérisée en ce que** la première antenne d'interférence (30) et la seconde antenne d'interférence (34) sont sélectivement connectées à l'au moins un générateur de signal d'interférence (28, 32) par le biais d'une unité de commutation d'antenne (48) du système de mesure (14) ou **en ce que** le système de mesure (14) comprend deux générateurs de signal d'interférence (28, 32) connectés à la première antenne d'interférence (30) et à la seconde antenne d'interférence (34), respectivement.

6. Configuration de mesure selon l'une quelconque des revendications précédentes, **caractérisée en ce que** le système sous test (12) comprend un second dispositif radio (22) supportant une seconde norme de communication, en particulier dans laquelle le signal d'interférence (S_{I}) est un signal selon la seconde norme de communication.

7. Configuration de mesure selon la revendication 6, **caractérisée en ce que** le premier dispositif radio (20) et le second dispositif radio (22) sont intégrés sur la même puce du système sous test (12).

8. Configuration de mesure selon l'une quelconque des revendications précédentes, **caractérisée en ce que** le système sous test (12) comprend un véhicule (16), en particulier dans laquelle l'au moins une première antenne d'interférence (30), l'au moins une seconde antenne d'interférence (34) et/ou l'antenne de communication (46) sont placées à l'intérieur du véhicule (16).

9. Configuration de mesure selon la revendication 8, **caractérisée en ce que** la première antenne d'interférence (30) et/ou la seconde antenne d'interférence (34) est positionnée dans une plage d'environ une ou plusieurs largeurs de ligne et/ou d'environ une ou plusieurs dimensions de véhicule à distance du système sous test (12).

10. Procédé permettant de tester un système sous test (12) avec au moins un premier dispositif radio (20), en particulier pour des tests de proximité par voie aérienne, à l'aide d'une configuration de mesure (10) selon l'une quelconque des revendications précédentes, le procédé comprenant les étapes suivantes :
a) établissement d'une liaison de communication (C) par voie aérienne entre le testeur de communication (26) et l'au moins un premier dispositif radio (20) par le biais du testeur de communication (26) émettant un signal de communication (C),
b) émission d'au moins un signal d'interférence (S_{I}) dirigé vers le système sous test (12), et
c) évaluation de la qualité de la liaison de communication (C), en particulier par le testeur de communication (26)
**caractérisé en ce que** la puissance de signal d'interférence émise de l'au moins une antenne d'interférence (30, 34) dépend d'un faisceau d'antenne d'interférence de l'antenne d'interférence (30, 34) par rapport au système sous test (12).

11. Procédé selon la revendication 10, **caractérisé par** les étapes suivantes :
a) réglage de la position relative et/ou de l'alignement relatif du système sous test (12) et de l'antenne de communication (46) jusqu'à ce que le couplage maximal entre l'antenne de communication (46) et le premier dispositif radio (20) soit atteint,
b) réduction de la puissance du signal de communication à une puissance réduite jusqu'à ce qu'une détérioration prédéfinie de la qualité de la liaison de communication (C) soit obtenue,
c) enregistrement de la valeur de la puissance réduite,
d) augmentation de la puissance du signal de communication à une puissance de test, en particulier à une pleine puissance,
e) augmentation de la puissance de l'au moins un signal d'interférence (S_{I}) à une puissance d'interférence jusqu'à ce que la qualité de la liaison de communication (C) se soit détériorée à la détérioration prédéfinie, et
f) détermination d'un niveau de blocage en fonction de la valeur de la puissance réduite et de la valeur de la puissance d'interférence, en particulier la position d'interférence (P_{I1}, P_{I2}), l'alignement de l'au moins une antenne d'interférence (30, 34) et/ou la position et/ou l'alignement de l'antenne de communication (46) par rapport au système sous test (12) étant utilisés pour déterminer le niveau de blocage.

12. Procédé selon la revendication 10 ou 11, **caractérisé en ce que** l'au moins une antenne d'interférence (30, 34) est placée au niveau d'une première position d'interférence (P_{I1}) pour une première phase du procédé et l'au moins une antenne d'interférence (30, 34) est placée au niveau d'une seconde position d'interférence (P_{I2}) pour une seconde phase du procédé.

13. Procédé selon l'une quelconque des revendications 10 à 12, **caractérisé en ce que** le système sous test (12), en particulier le véhicule (16), est mis en rotation par rapport à l'antenne de communication (46) à l'aide d'un mécanisme de rotation (38), en particulier une plaque tournante.
